# EUROPEAN PATENT SPECIFICATION

(11) **EP 1 628 394 B1**
(45) Date of publication and mention of the grant of the patent: **10.10.2007**
(21) Application number: 04734360.3
(22) Date of filing: 21.05.2004
(51) Int. Cl.: H03G 3/30

(54) **DETECTION CIRCUIT AND DETECTION CIRCUIT ADJUSTMENT METHOD**
DETEKTIONSSCHALTUNG UND DETEKTIONSSCHALTUNGSEINSTELLVERFAHREN
CIRCUIT DE DETECTION ET PROCEDE D'AJUSTEMENT DUDIT CIRCUIT

(30) Priority: 23.05.2003 JP 2003146222
(43) Date of publication of application: 22.02.2006
(73) Proprietor: MATSUSHITA ELECTRIC INDUSTRIAL CO., LTD, Kadoma-shi, Osaka 571-8501 (JP)
(72) Inventor: TATENO, Yoshihide, x (JP); KOSAKA, Hirofumi, x (JP); SASAKI, Makoto, x (JP)
(74) Representative: Schuster, Thomas
(86) International application number: PCT/JP2004/007287
(87) International publication number: WO 2004/105236

(56) References cited:
- EP-A- 0 859 462
- EP-A- 1 309 094
- GB-A- 2 359 678
- JP-A- 9 008 766
- JP-A- 11 174 143
- PATENT ABSTRACTS OF JAPAN vol. 1999, no. 12, 29 October 1999 (1999-10-29) & JP 11 174143 A (MITSUBISHI ELECTRIC CORP), 2 July 1999 (1999-07-02)

## Description

### Technical Field

The present invention relates to a detection circuit that detects the signal level of an input signal, transmission apparatus and reception apparatus provided with the detection circuit and a method of adjusting the detection circuit.

### Background Art

As a conventional detection circuit, for example, one described in Japanese Patent Application Publication No.HEI11-174143 is known.

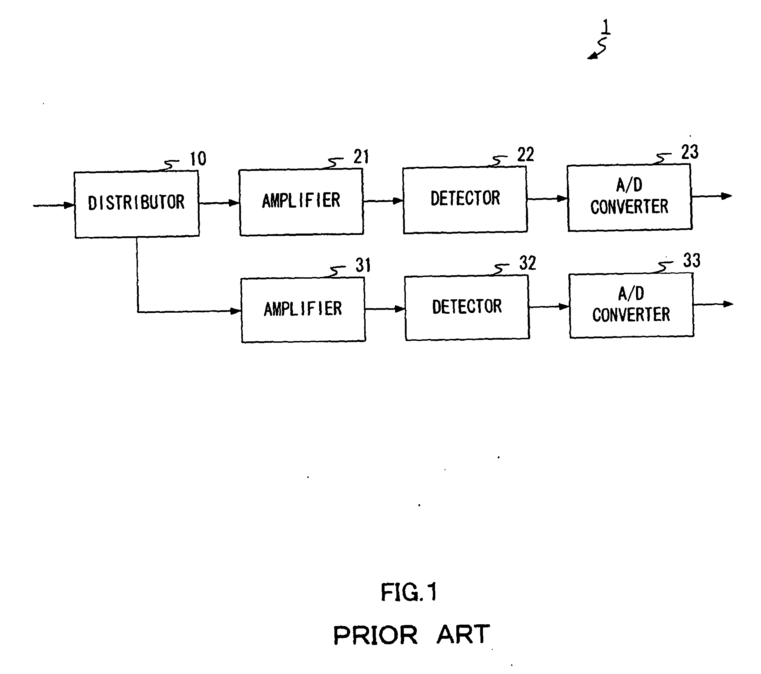

FIG.1 is a block diagram showing main components of this conventional detection circuit.

Detection circuit 1 shown in FIG. 1 is provided with: distributor 10 that distributes an input signal; a plurality (2 here) of amplifiers 21, 31 that amplify the distributed signals by different gains; detectors 22, 32 that detect the signals amplified by different gains; and A/D converters 23, 33 that convert and output the detected values.

Detectors 22, 32 have the same detection characteristics and, as their general characteristics, the range (detection range) of input signal level in which the detection characteristics show linearity is limited.

For this reason, detection circuit 1 sets the gain in amplifier 21 to a smaller value than the gain in amplifier 31 and outputs detected signals of different levels to detectors 22, 32.

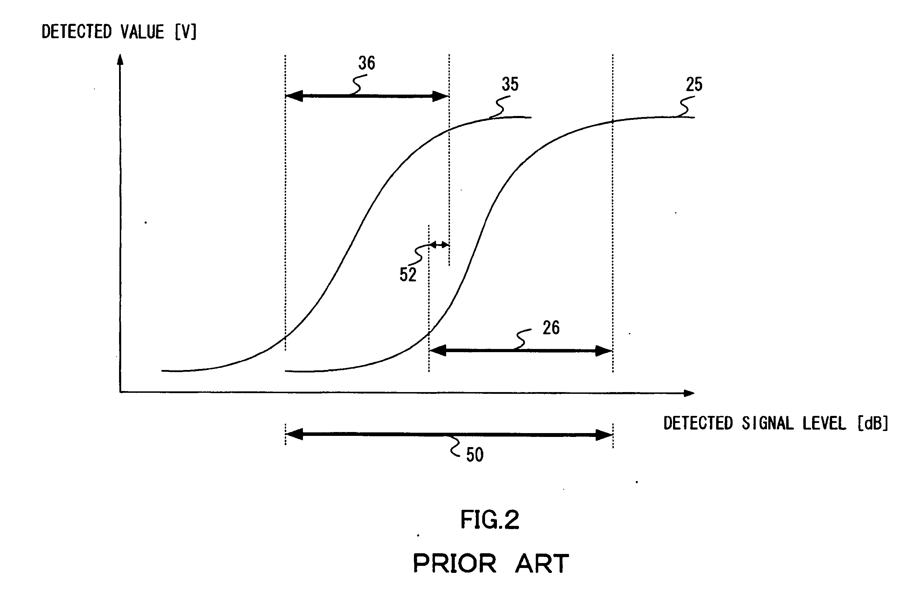

FIG.2 is a characteristic diagram of detection circuit 1 showing the relationship between the level of a detected signal input to distributor 10 and detected values detected by detectors 22, 32. In the figure, characteristic curve 25 shows the output of detector 22 and characteristic curve 35 shows the output of detector 32.

As shown in FIG.2, detectors 22, 32 have different signal levels of their respective input signals, and therefore the range in which detectors 22, 32 show linearity, that is, detection ranges 26, 36 of detectors 22, 32 are shifted in the detected signal level direction, and, in this way, detection circuit 1 is in a state in which its dynamic range (detection range 50 of the input signal level detectable as the entire detection circuit) is expanded.

Note that as shown in FIG.2, detection circuit 1 needs sufficient margin 52 where the lowermost portion of the linear part of characteristic curve 25 indicating detection range 26 of detector 22 and the uppermost portion of the linear part of characteristic curve 35 indicating detection range 36 of detector 32 overlap with each other sufficiently.

This is because amplifiers 21, 31 and detectors 22, 32 actually have characteristic variations and there are cases where these characteristic variations increase the gain difference between amplifier 21 and amplifier 31 and causes the characteristic curve of detector 32 to have linearity at a smaller level than the detected signal level at which characteristic curve 25 of detector 22 loses linearity.

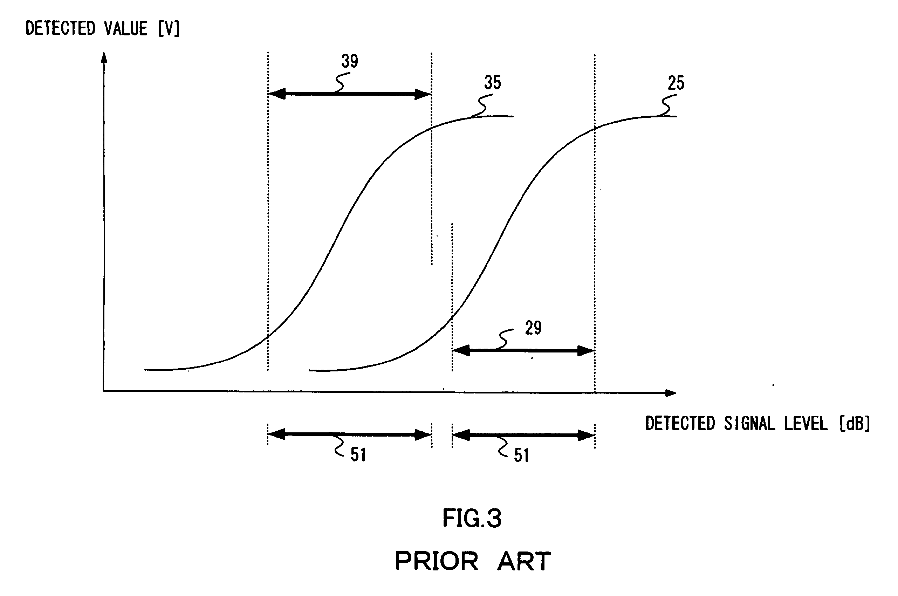

FIG.3 is a characteristic diagram when the gain difference between the plurality of amplifiers 21, 31 in detection circuit 1 is large and shows the relationship between the level of the detected signal input to distributor 10 and the detected values detected by detectors 22, 31 when the gain difference between the plurality of amplifiers 21 and 23 is large.

As shown in FIG.3, the dynamic range of detection circuit 1 with respect to the detected signal level becomes discontinuous as shown with discontinuous detection range 51 and both characteristic curve 25 and characteristic curve 35 have a small amount of variation of the detected values with respect to the detected signal level within discontinuous detection range 51 and either one or both of the detected values reduces the detection accuracy.

For this reason, detection circuit 1 takes sufficient margin 52 in such a way that detection ranges indicating the linearity of characteristic curves 25, 35 of the respective detectors overlap with each other in consideration of the amount of characteristic variations in amplifiers 21, 31 and detectors 22, 32 in actual circuit design and manufacturing.

Furthermore, detection circuit 1 of this kind is used in a transmission and reception apparatus having an automatic gain control (AGC) function for outputting a signal at a desired signal level or receiving a signal at a desired reception level.

For example, when the above described detection circuit 1 is used in a transmission apparatus having an AGC function, the transmission apparatus will be configured such that a signal is amplified by a gain so that the signal has a desired signal level through a variable gain amplifier, part of a transmission signal output to an antenna is detected, and gain control is performed over the variable gain amplifier using this detected value.

This transmission apparatus can recognize a transmission signal level of a transmission apparatus through detection circuit 1 by storing the correspondence between the transmission signal level from the antenna and detected value at the detection circuit in advance. In such a case, detection circuit 1 can receive the transmission signal with an expanded dynamic range can receive, the transmission signal, and, when the transmission signal level is different from the desired value, performs a loop control by sending a gain control signal to the variable gain amplifier and implements the AGC function.

However, in order to prevent deterioration in accuracy due to characteristic variations in amplifiers 21, 31 and detectors 22, 32, conventional detection circuit 1 secures the range in which the characteristic curves of detectors 22, 32 show linearity, that is, a certain margin (a relatively large margin with characteristic variations of detection circuits 22, 32 taken into consideration) 52 in such a way that detection ranges 26, 36 of detection circuits 22, 32 overlap with each other sufficiently, and therefore the respective detection ranges 26, 36 of detection circuits 22, 32 narrows by the proportion of secured margin 52, which results in the problem that the dynamic range that can be realized as detection circuit 1 as a whole becomes narrower.

Furthermore, in order to realize the dynamic range for the entire detection circuit 1 in the above described configuration, amplifiers 21, 31 and detectors 22, 32 may be adjusted individually, but the problem is that such adjustment work takes much time and effort.

Furthermore, when the AGC function is realized by using detection circuit 1 in the above described configuration for the transmission and reception apparatus, the dynamic range when receiving a signal becomes narrower than the dynamic range which can be detected from the configuration, and therefore the signal level range of signals subjected to gain control is limited and it is impossible to fully use the AGC function.

### Disclosure of Invention

It is an object of the present invention to provide a detection circuit capable of readily expanding the dynamic range while preventing deterioration of detection accuracy due to characteristic variations of devices such as amplifiers and detectors and fully realizing an AGC function when used in a transmission apparatus and reception apparatus, a transmission apparatus and reception apparatus provided with this detection circuit and a method of adjusting the detection circuit.

The above described object is achieved by a detection circuit according to claim 1 and by a method of detecting according to claim 6.

### Brief Description of Drawings

FIG.1 is a block diagram showing main components of a conventional detection circuit;
FIG.2 is a characteristic diagram of a conventional detection circuit; .
FIG.3 is a characteristic diagram of a conventional detection circuit when there is a large gain difference between a plurality of amplifiers;
FIG.4 is a block diagram showing the configuration of a detection circuit according to Embodiment 1 of the present invention;
FIG.5 is a characteristic diagram of a detection circuit according to Embodiment 1 of the present invention;
FIG.6 is a characteristic diagram of a detection circuit according to Embodiment 1 of the present invention;
FIG.7 is a characteristic diagram of a detection circuit according to Embodiment 1 of the present invention;
FIG.8 is a block diagram showing the configuration of a detection circuit as a modification example of Embodiment 1 of the present invention;
FIG.9 is a block diagram showing the configuration of a detection circuit according to Embodiment 2 of the present invention;
FIG.10 is a block diagram showing the configuration of a detection circuit according to Embodiment 3 of the present invention;
FIG.11 is a block diagram showing the configuration of a detection circuit according to Embodiment 4 of the present invention;
FIG. 12 is a block diagram showing the configuration of a transmission apparatus according to Embodiment 5 of the present invention; and
FIG.13 is a block diagram showing the configuration of a reception apparatus according to Embodiment 6 of the present invention.

### Best Mode for Carrying out the Invention

With reference now to the accompanying drawings, embodiments of the present invention will be explained in detail below.

### (Embodiment 1)

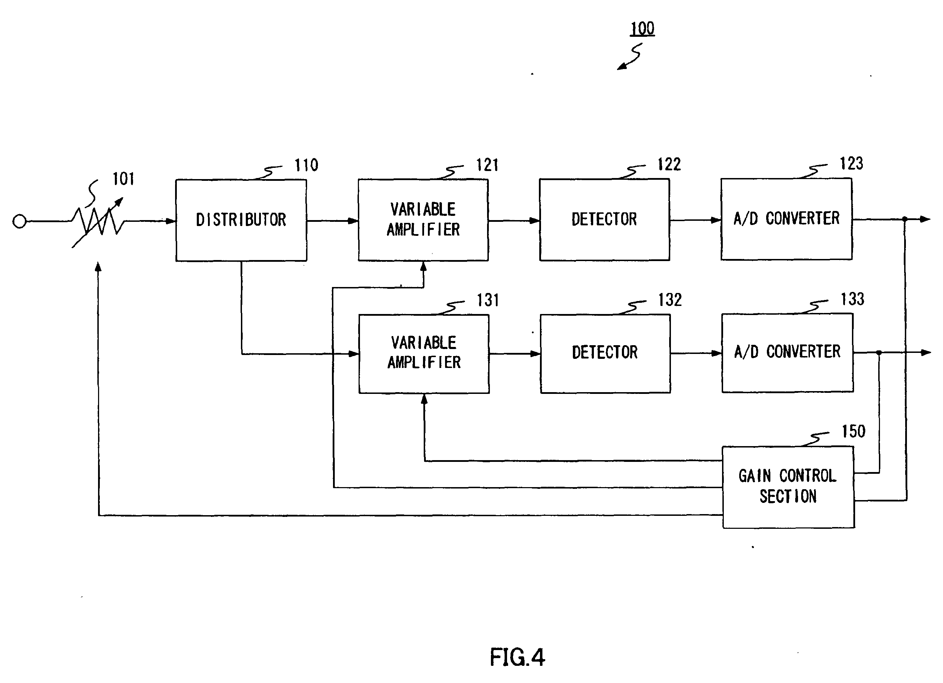

FIG.4 is a block diagram showing the configuration of a detection circuit according to Embodiment 1 of the present invention.

Detection circuit 100 shown in FIG.4 is provided with variable attenuator 101, distributor 110, a plurality (2 here) of variable amplifiers 121 and 131, a plurality (here two) of detectors 122, 132, a plurality (2here) of A/D converters 123, 133 and gain control section 150.

Variable attenuator 101 is detachably provided in the input stage of detection circuit 100 and is able to control the amount of attenuation using an attenuation control signal input from gain control section 1 50 and attenuates an input detected signal by the set amount of attenuation and outputs the signal to distributor 110.

Distributor 110 distributes the signal attenuated by a predetermined amount of attenuation to a plurality of identical signals and outputs the signals to variable amplifier 121 and variable amplifier 131.

Variable amplifier 121 and variable amplifier 131 can control gains using a gain control signal from gain control section 150, amplify the signals output from distributor 110 by respective predetermined gains (first gain and second gain) and output the signals to detector 122 and detector 132.

Detector 122 and detector 132 carry out linear detection on the detected signals output from variable gain amplifier 121 and variable gain amplifier 131 and output the signals to A/D converter 123 and A/D converter 133 respectively.

These detector 122 and detector 132 have substantially the same characteristic, and, with each, the detection range of input signal level in which the detection characteristics show linearity is limited. That is, when the input signal level is larger than a certain upper limit level, the detected values of detectors 122, 132 saturate and signals are not detected correctly. On the other hand, when the input signal level is lower than a certain lower limit level, detected values do not substantially change and signals are not detected correctly due to the influence of noise.

A/D converter 123 and A/D converter 133 quantize output signals (here, convert them to digital values) from detector 122 and 132 and output the results.

Gain control section 150 controls the amount of attenuation in variable attenuator 101, gains in variable amplifier 121 and variable amplifier 131 and reads output signals from A/D converter 123 and A/D converter 133 and thereby monitors the detected values of detector 122 and detector 132.

More specifically, gain control section 150 adjusts the gains in variable amplifier 121 and variable amplifier 131, increases or decreases the amount of attenuation in variable attenuator 101 for each adjusted gain and changes the signal level to be output to distributor 110. Then, gain control section 150 reads the degree of variation of the detected values from the digitized output signals output from A/D converter 123 before and after the signal level is changed. Gain control section 150 adjusts and determines the gains in variable amplifier 121 and variable amplifier 131 in such a way that they have the degree of variation of detected values effective for the detection accuracy of the detected signal levels.

That is, gain control section 150 has the gain determining function of controlling attenuator 101 and making the level of output signals vary, while also controlling variable amplifier 121 and variable amplifier 131 and adjusting then gains in variable amplifiers 121, 131, thereby determining the gains in variable amplifiers 121 and 131 respectively such that the lower limit value of the detection range of detector 122 and the upper limit of the detection range of the detection range of detector match.

Furthermore, the gains in variable amplifier 121 and variable amplifier 131 controlled by gain control section 150 are set such that the gain in amplifier 121 is set smaller than gain in amplifier 131 and the level of signals output to detector 122 is set smaller than the level of the signal output to detector 132.

In this way, the detection section formed with variable amplifier 121, detector 122 and A/D converter 123 in the detection circuit, detects strong signal levels, and the detection section formed with variable amplifier 131, detector 132 and A/D converter 133, detects weak signal levels.

Next, the operation of detection circuit 100 having the above described configuration will be explained.

First, a signal of a maximum level to be detected by detection circuit 100 according to this embodiment is input to the input stage of variable attenuator 101. At this time, gain control section 150 controls variable attenuator 101 and variable amplifier 121 and sets the amount of attenuation in variable attenuator 101 to a minimum value and the gain in variable amplifier 121 to a sufficiently large value.

Next, gain control section 150 changes the gain in variable amplifier 121 and thereby performs adjustment such that the upper limit value of the linear part of the detection characteristic curve of detector 122 matches the maximum level value of the detected signal level.

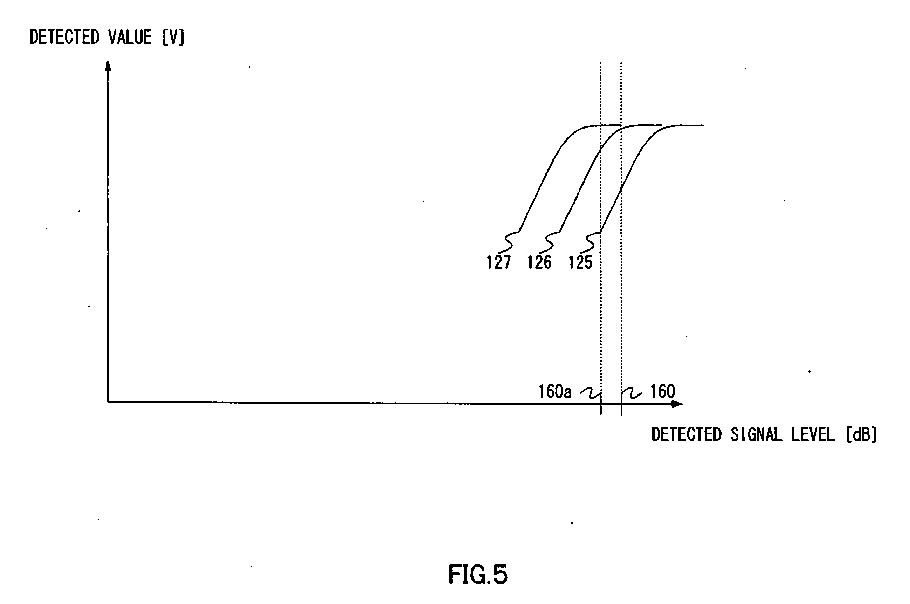

FIG.5 is a characteristic diagram of the detection circuit according to this embodiment, and, more specifically, shows the detection characteristic curve of detector 122 adjusted by changing the gain in variable amplifier 121.

In FIG.5, characteristic curves 125 to 127 of detector 122 shift leftward as the gain in variable amplifier 121 increases under the control of gain control section 150.

Furthermore, the detected signal level on the horizontal axis in the figure is the output signal level of variable attenuator 101 and point 160 represents the signal level when a maximum input signal level at the detection circuit of the present invention is input and the amount of attenuation in variable attenuator 101 is set to a minimum.

Gain control section 150 reduces the detected signal level from point 160 of the maximum input signal level to point 160a by increasing the amount of attenuation in variable attenuator 101 as appropriate and reads the degree of variation of the detected value from the output signal digitized by A/D converter 123.

First, in the case of characteristic curve 127 of detector 122 where the largest gain is set, even if the detected signal level is changed from point 160 to point 160a, the detected value does not change substantially, and the detected value is already saturated at detector 122, and it is determined insufficient for the level of detection accuracy.

For this reason, after the gain in variable amplifier 121 is reduced, the amount of attenuation in variable attenuator 101 is adjusted and the detected signal level is changed from the state of point 160 to point 160a. The characteristic curve at this time is shown with reference numeral 126.

In the state of this characteristic curve 126, the detected values between point 160 and point 160a is small, and it is determined insufficient for the accuracy of level detection.

The gain in variable amplifier 121 is reduced again and then the detected value is read. Characteristic curve 125 of detector 122 at this time shows that the detected value changes between point 160 and point 160a in appropriate magnitude for the first time. That is, linear part 125a is detected to be positioned within that level range.

In this way, gain control section 150 decides that linear part 125a of characteristic curve 125 of detector 122 required for the accuracy of level detection is set in a state in which the upper limit value thereof matches the maximum signal level value of detection circuit 100 and determines the gain in variable amplifier 121 at this time as the gain in variable amplifier 121.

Hereinafter, gain control section 150 increases the amount of attenuation in variable attenuator 101 and reduces the detected signal level.

Next, gain control section 150 changes the gain in variable amplifier 131 and thereby makes adjustment so that the upper limit value of the linear part of the detection characteristic curve of detector 132 matches the lower limit value of the linear part of the detection characteristic curve of detector 122.

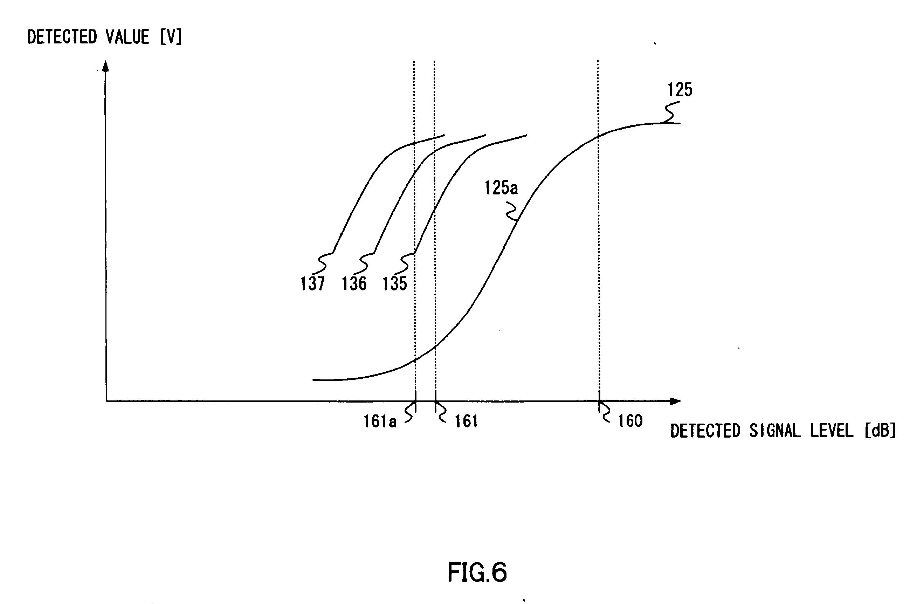

FIG.6 is a characteristic diagram of the detection circuit illustrating the operation of the detection circuit according to Embodiment 1 of the present invention and more specifically shows the detection characteristic curve of detector 132 adjusted by changing the gain in variable amplifier 131. Characteristic curves 137 to 135 of the detector in FIG.6 shift leftward as the gain in variable amplifier 131 increases as in the case of characteristic curves 125 to 127.

As shown in FIG.6, when the detected signal level is decreased, gain control section 150 detects that the amount of variation of characteristic curve 125 decreases when the detected signal level shifts from 161a to 161. Through this reduction in the amount of variation, gain control section 150 decides that linear part 125a of detector 122 is over.

Then, gain control section 150 adjusts the gain in variable amplifier 131 and starts making adjustment so that detector 132 can detect the range in which the detected signal level is smaller than at point 161.

With regard to the adjustment of the gain in variable amplifier 131 by gain control section 150, as in the case where the gain in variable amplifier 121 is determined, the gain in variable amplifier 131 is determined by adjusting the amount of attenuation in variable attenuator 101, changing the detected signal level at points 161 and 161a alternately and monitoring the extent of change of the detected value. With regard to the gain adjustment of variable amplifier 131, the same result can be obtained by decreasing the gain in variable amplifier 131 sequentially from a sufficiently large gain and finding the gain at which the detected value changes for the first time, and on the other hand, by increasing the gain from a small gain sequentially and finding the gain at which the detected value starts to saturate.

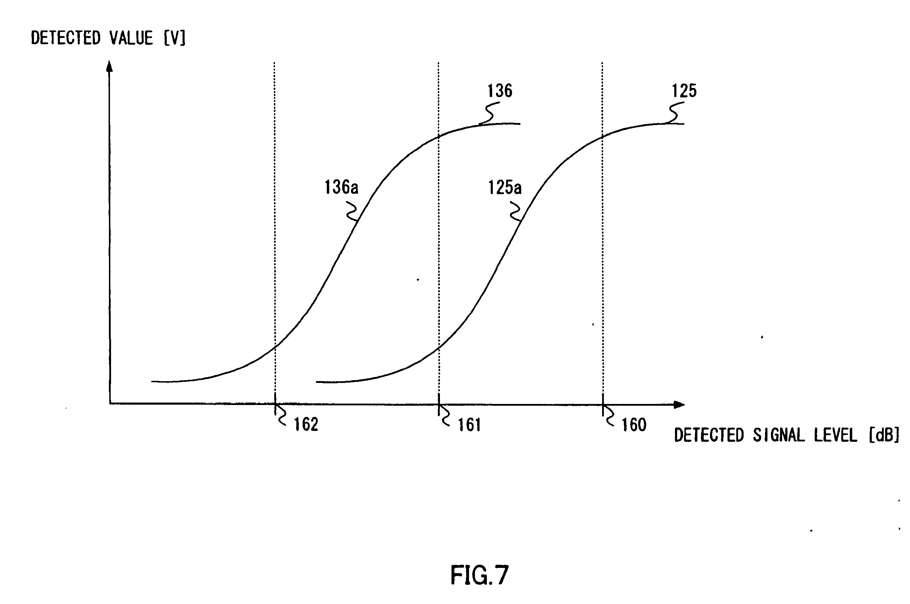

FIG.7 is a characteristic diagram illustrating the operation of the detection circuit according to Embodiment 1 of the present invention and more specifically shows the detection curves of detector 122 and detector 132 after the gain in variable amplifiers 131 is determined.

As shown in FIG.7, after the gain in variable amplifier 131 is determined, in gain control section 150, when the amount of attenuation in variable attenuator 101 further increases, the amount of variation of characteristic curve 136 decreases when the detected signal level becomes smaller than at point 162.

At point 162 at which the amount of variation of characteristic curve 136 has reduced, gain control section 150 detects that linear part 136a of detector 132 is over.

Finally, the gains in variable amplifier 121 and variable amplifier 131 have been determined, and therefore gain control section 150 returns the amount of attenuation in variable attenuator 101 to a minimum value. When the detection circuit of the present invention is actually used to detect an unknown signal, the amount of attenuation in variable attenuator 101 is kept at a minimum.

Thus, according to this embodiment, variable attenuator 101 is provided at the input stage of the detection circuit to adjust the level of the detected signal, the gains in variable amplifier 121 and variable amplifier 131 are adjusted so that the lower limit value of linear part 125a of the characteristic curve of detector 122 matches the upper limit value of linear part 136a of the characteristic curve of detector 132, and therefore it is possible to use the respective detection ranges of detector 121 and detector 131 to a maximum extent and make it easy to accomplish a detection circuit having a wide dynamic range.

This embodiment adopts the configuration in which the detected signal is divided into two parts and the divided signals are detected by two detection sections, but the present invention is not limited to this, and the detected signal can be divided into three or more parts and the divided signals are detected by detection sections each comprised of a variable amplifier, a detector and an A/D converter. In that case, a configuration would be adopted in which gains vary from one amplifier to another and signal levels are output at different levels.

Thus, the detection circuit is configured to perform detection with three or more detection sections so that the detected signals are amplified by respective gains in the respective detection sections and the overall linearity is secured, it is possible to make full use of the detection ranges of detectors and realize detection circuit 1 having a wider dynamic range.

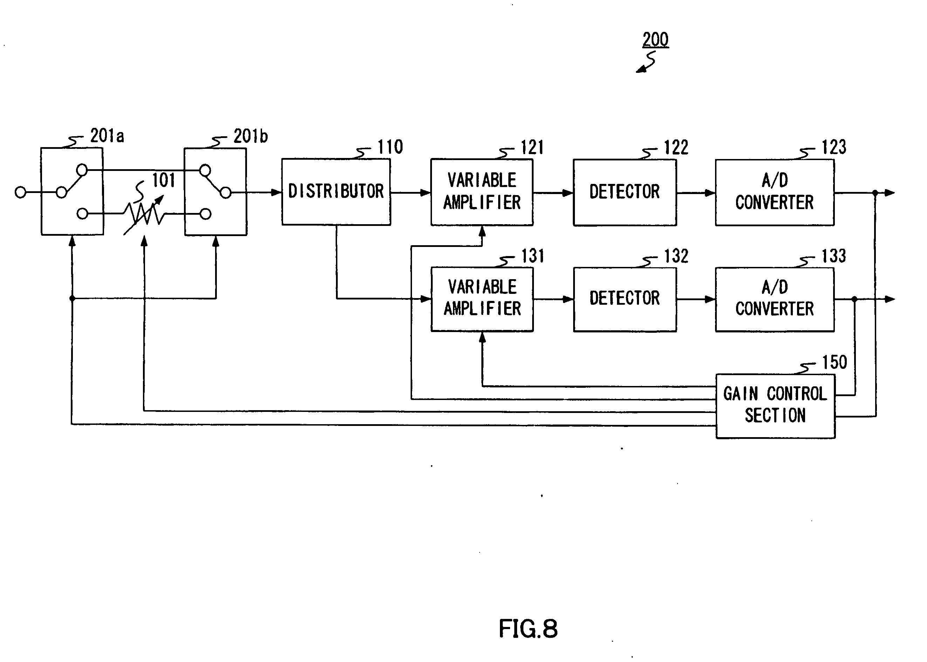

FIG.8 is a block diagram showing the configuration of a detection circuit as a modification example of Embodiment 1. Detection circuit 200 shown in FIG.8, in the above described detection circuit 100, provides switch 201a and switch 201b that can switch an input detection signal to either variable attenuator 101 or distributor 110 at the input stage of detection circuit 100.

This detection circuit 200 can be adopted in such a way that variable attenuator 101 is used only when the gains in variable amplifier 121 and variable amplifier 131 are determined through change by switch 201a and 201b and the detected signal may bypass variable attenuator 101 when not necessary. This allows detection circuit 200 to reduce loss when actually detecting an unknown input signal level.

Note that in detection circuits 100 and 200, it is possible to remove variable attenuator 101 and gain control section 150 and use the detection circuit after the gains invariable amplifier 121 and variable amplifier 131 are determined.

Furthermore, in the above described detection circuit 100, variable attenuator 101 may be substituted by an arbitrary signal generator controlled by gain control section 150 which can generate a signal arbitrarily and output the signal to distributor 110. In this case, after the gains in variable amplifier 121 and variable amplifier 131 are determined, the signal generator is removed and the detection circuit is used.

Note that the accuracy of the detection circuit of the present invention can be improved by appropriately setting the count of attenuation amount adjusting steps in variable attenuator 101 and a threshold value for deciding whether or not the detected value has linear characteristics.

### (Embodiment 2)

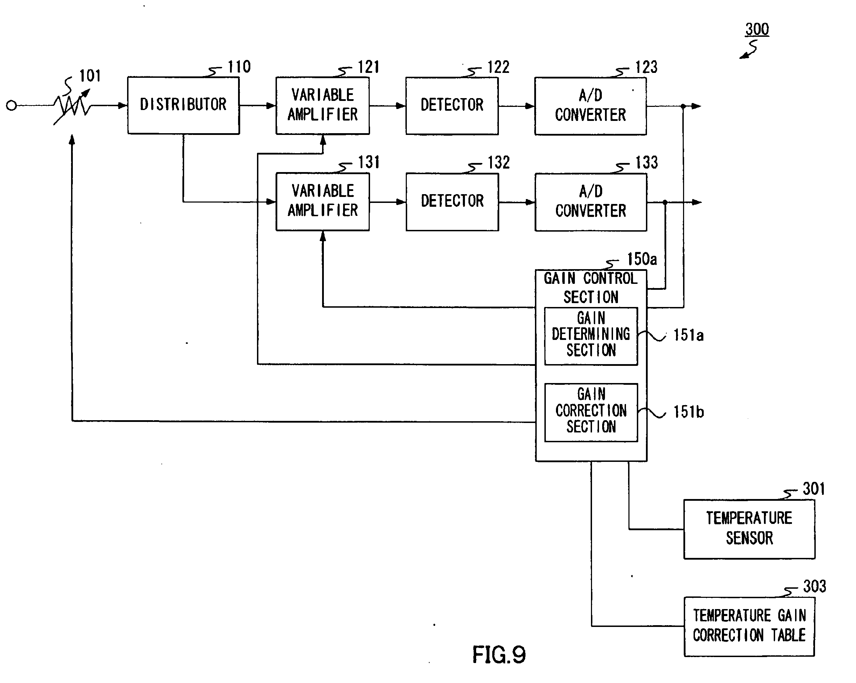

FIG.9 is a block diagram showing the configuration of a detection circuit according to Embodiment 2 of the present invention. Detection circuit 300 shown in this figure has maintains the same basic configuration from detection circuit 100 corresponding to Embodiment 1 shown in FIG.4, and the same components are assigned the same reference numerals and explanations thereof will be omitted.

Detection circuit 300 includes detection circuit 100 of Embodiment 1, temperature sensor 301 that measures temperature and temperature gain correction table 303.

Temperature sensor 301 measures temperatures around detection circuit 300 and outputs the measured information to gain correction section 151b of gain control section 150a.

Furthermore, temperature gain correction table 303 stores the amounts of compensation for compensating the respective temperature characteristics of detector 122 and detector 132 in association with temperatures and the amounts of gain correction corresponding to these amounts of compensation are stored, all readable from gain controller 150a.

Here, the amount of gain correction will be explained.

Detector 122 and detector 132 respectively have temperature characteristics just like a general detector, and the ambient temperature may change detection characteristics and may deteriorate their detection accuracy. That is, though detector 122 and detector 132 are adjusted such that the lower limit value of linear part 125a of the detection curve of detector 122 matches the upper limit value of linear part 136a of detection curve 136 of detector 132 in a certain temperature environment, the detected values of detector 122 and detector 132 may change in a different temperature environment and the lower limit value of linear part 125a of the detection curve of detector 122 may deviate from the upper limit value of linear part 136a of detection curve 136 of detector 132, causing deterioration of the detection accuracy and the narrower dynamic range.

To cope with this problem, even when difference or overlapping is produced between the lower limit value of linear part 125a of the detection curve of detector 122 and the upper limit value of linear part 136a of detection curve 136 of detector 132 depending on the temperature, the amount of correction stored in temperature gain correction table 303 corresponds to an amount by which the difference or overlapping is eliminated and the gains in variable amplifiers 121 and 131 are corrected in such a way that the lower limit value of linear part 125a of the detection curve of detector 122 matches the upper limit value of linear part 136a of detection curve 136 of detector 132.

Gain control section 150a includes gain determining section 151a and gain correction section 151b.

Gain determining section 151a acts in the same way as gain control section 150 , controls variable attenuator 101 and make the level of the signal output variable, and at the same time controls variable amplifier 121 and variable amplifier 131 to adjust the gains in these variable amplifiers 121 and 131 and thereby determines the respective gains in variable amplifiers 121 and 131 in such a way that the lower limit value of the detection range (see linear part 125a in FIG.7) of detector 122 matches the upper limit value of the detection range (see linear part 136a in FIG.7) of detector 132.

Furthermore, gain correction section 151b corrects the respective gains in variable amplifiers 121 and 131 determined by gain determining section 151a based on the ambient temperature detected by temperature sensor 301 using temperature gain correction table 303. More specifically, gain correction section 151b reads information on temperatures around the circuit from temperature sensor 301 and at the same time reads an amount of correction corresponding to the temperature information read from temperature gain correction table 303. Furthermore, gain correction section 150b corrects the gains in variable amplifier 121 and variable amplifier 131 by increasing or decreasing the gains by the amount of correction based on the amount of correction read.

Next, the operation of detection circuit 300 in the above described configuration will be explained.

In gain control section 150a, similar to gain control section 150, the gains in respective variable amplifiers 121 and 131 are determined at gain determining section 151a so that the lower limit value of the detection range (see linear part 125a in FIG.7) of detector 122 matches the upper limit value of the detection range (see linear part 136a in FIG.7) of detector 132.

In addition, gain control section 150a obtains information on temperatures around the circuit from temperature sensor 301 through gain correction section 151b, reads the amount of correction at the corresponding temperature from temperature gain correction table 303, controls variable amplifier 121 and variable amplifier 131 to increase or decrease the gains in variable amplifier 121 and variable amplifier 131 by an amount of correction.

Detector 122 and detector 132 detect the signals whose temperature characteristic have been corrected and gain control section 150 a monitors the detected values output from A/D converter 123 and A/D converter 133.

Note that a temperature variation at the detection circuit of the present invention can be reduced by causing temperature gain correction table 303 by storing also the amount of correction taking the temperature characteristic of distributor 110, variable amplifier 121 and variable amplifier 131 into consideration in temperature gain correction table 303.

Furthermore, it is also possible to adopt temperature gain correction table 303 to store amounts of compensation in correspondence with temperatures by which the temperature characteristics of detector 122 and detector 132 are compensated, store amounts of correction of variable attenuator 101 corresponding to these amounts of compensation and read the amounts of correction of this attenuator 101 by gain control section 150a. The above mentioned configuration makes it possible to perform controlling in such a way that the detected values output from detector 122 and detector 132 become identical irrespective of the ambient temperature and maintain the continuity of the detection range by changing the amount of suppression of variable attenuator 101 without correcting the gains in variable amplifier 121 and variable amplifier 131.

In this way, temperature sensor 301 and temperature gain correction table 303 provided in this embodiment adjust the gains in variable amplifier 121 and variable amplifier 131 even if the characteristics of detector 122 and detector 132 change according to temperatures and therefore, the detection characteristic of the detection circuit as a whole is made difficult to change and a detection circuit with little deterioration of the detection characteristic associated with temperatures can be realized.

### (Embodiment 3)

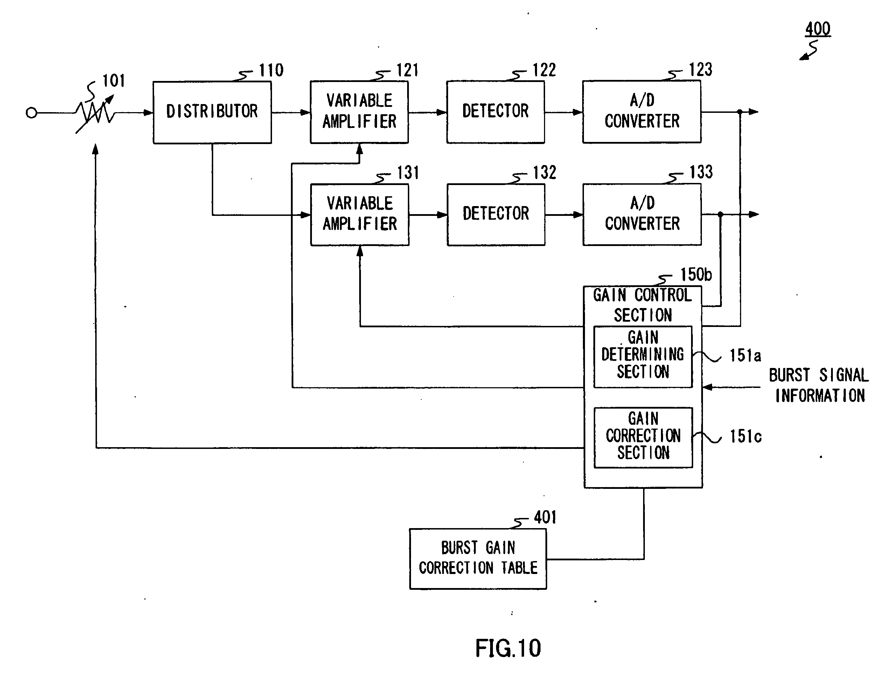

FIG.10 is a block diagram showing the configuration of a detection circuit according to Embodiment 3 of the present invention. Detection circuit 400 shown in FIG.10 has a basic configuration similar to that of detection circuit 100 corresponding to Embodiment 1 shown in FIG.4 and the same components are assigned the same reference numerals and explanations thereof will be omitted.

Detection circuit 400 includes detection circuit 100 and burst gain correction table 401.

In general, when a signal whose level changes drastically with time (burst signal) is detected, the accuracy of level detection of a detector deteriorates. That is, when detector 122 and detector 132 detect burst signals from variable amplifier 121 and variable amplifier 131 respectively, the lower limit value of linear part 125a of the detection curve of detector 122 that is adjusted so that the respective detected values change and match with each other differs from the upper limit value of linear part 136a of detection curve 136 of detector 132, which results in the deterioration in the detection accuracy and narrow dynamic range.

For this reason, burst gain correction table 401 stores the amounts of gain to be increased or decreased (amount of correction) of variable amplifier 121 and variable amplifier 131 according to the frequency with which a detected signal bursts. The amounts of gain to be increased or decreased of variable amplifier 121 and variable amplifier 131 may be amounts of increase and decrease corresponding to the magnitude of the burst.

Furthermore, gain control section 150b includes a gain determining section 151a and a gain correction section 151c. Gain determining section 151a has a configuration similar to that of gain determining section 151a of Embodiment 1, and therefore explanations thereof will be omitted.

When burst signal detection information is input from a burst signal detector (not shown), gain correction section 151c recognizes the burst states of signals input to variable amplifiers 121 and 131 and corrects the gains in variable amplifiers 121 and 131 determined by gain determining section 151a using burst gain correction table 401.

In this regard, the burst signal detector (not shown) can be a baseband signal processing section that processes signals output fromA/D converters 123, 133. For example, when provided for a reception apparatus, the baseband processing section having a demodulator and suchlike calculates the power of the signal output from the demodulator, generates burst signal detection information from a variation in the power value and outputs the information to gain correction section 151c.

Next, the operation of detection circuit 400 in the above described configuration will be explained.

Gain control section 150b first determines the gains in variable amplifiers 121 and 131 through gain determining section 151a.

When the burst signal detector (not shown) detects that the signal input to detection circuit 400 is a burst signal, burst signal information is input to gain correction section 151c of gain control section 150b and gain correction section 151c of gain control section 150b reads the amount of correction corresponding to the burst frequency from burst gain correction table 401 according to the input burst signal information or more specifically information on the state of the burst (here, how often burst occurs). Based on this amount of correction, gain control section 150b corrects the gains in variable amplifier 121 and variable amplifier 131 through gain correction section 151c, and causes the lower limit value of the detection range (see the linear part 125a in FIG.7) of detector 122 to match the upper limit value of the detection range (see linear part 136a in FIG. 7) of detector 132.

Thus, according to this embodiment, the gains in variable amplifier 121 and variable amplifier 131 change depending on how often burst occurs, bursts of an input signal, and therefore even when a burst signal is detected, detector 123 and detector 133 can detect the signals amplified by the gains subjected to burst correction from variable amplifier 121 and variable amplifier 131 and thereby reduce a detection error due to the difference between the lower limit value of linear part 125a of the detection curve of detector 122 and the upper limit value of linear part 136a of detection curve 136 of detector 132 which have been adjusted so as to match.

Therefore, it is possible to realize detection circuit 400 with a wide dynamic range and reduced detection errors.

This embodiment has adopted a configuration in which the gains in variable amplifier 121 and variable amplifier 131 are changed according to the frequency of bursts of an input signal and thereby reduce signal level detection errors generated due to the discontinuity of the detection ranges of detector 122 and detector 132, but this embodiment is not limited to this and it is also possible to maintain the continuity of detection ranges by keeping detected values output from detector 122 and detector 132 to the same value irrespective of the burst state of the input signal by changing the amount of suppression of variable attenuator 101 instead of the gains in variable amplifier 121 and variable amplifier 131.

### (Embodiment 4)

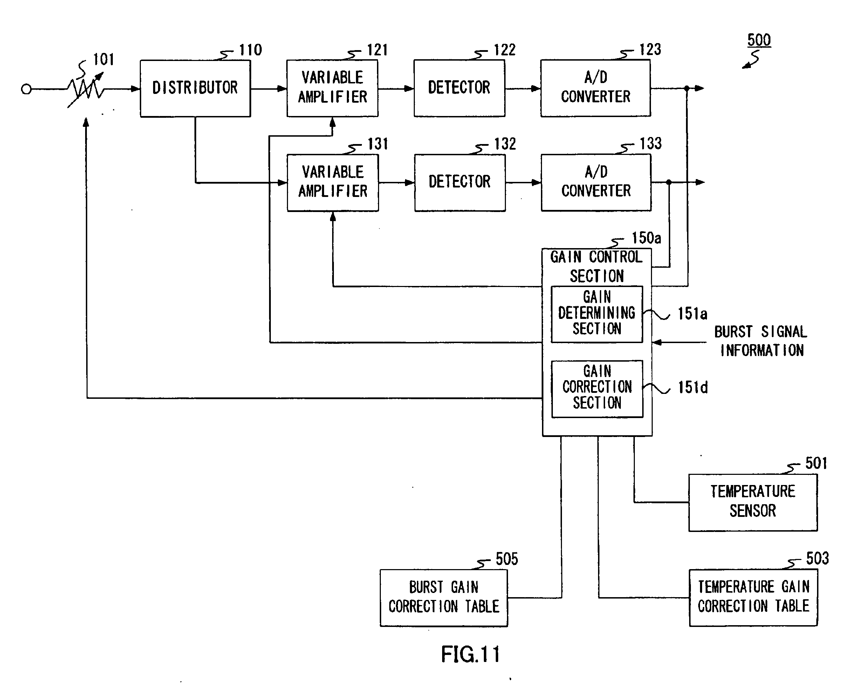

FIG.11 is a block diagram showing the configuration of detection circuit 500 according to Embodiment 4 of the present invention.

Detection circuit 500 shown in FIG.11 has a basic configuration similar to that of detection circuit 100 corresponding to Embodiment 1 shown in FIG.4 and the same components are assigned the same reference numerals and explanations thereof will be omitted.

Detection circuit 500 shown in FIG.11 includes detection circuit 100, temperature sensor 501, temperature gain correction table 503 and burst gain correction table 505.

Note that temperature sensor 501 and temperature gain correction table 503 have configurations similar to those of temperature sensor 301 and temperature gain correction table 303 of detection circuit 300 corresponding to Embodiment 2 and burst gain correction table 505 has a configuration similar to that of burst gain correction table 401 of detection circuit 400 corresponding to Embodiment 3, and therefore explanations thereof will be omitted.

Gain control section 150c includes gain determining section 151a and gain correction section 151d. Gain determining section 151a has a configuration similar to that of gain control section 150 of Embodiment 1 and therefore explanations thereof will be omitted.

Gain correction section 151d obtains an ambient temperature detected by temperature sensor 501, reads an amount of compensation at the temperature from temperature gain correction table 503 and based on this amount of correction increases or decreases the gains in variable amplifiers 121 and 131 determined by gain determining section 151a by the amount of correction.

Furthermore, when a burst signal detection information is input from a burst signal detector (not shown), gain correction section 151d recognizes the burst states of signals input to variable amplifiers 121 and 131, reads the amount of correction corresponding to the frequency for the relevant bursts from the burst gain correction table 505 and controls gains in variable amplifier 121 and variable amplifier 131 determined by gain determining section 151a based on this amount of correction.

Next, the operation of detection circuit 500 in the above described configuration will be explained.

Gain control section 150a determines the gains in variable amplifiers 121 and 131 through gain determining section 151a first.

As in the case of gain correction section 151b, gain control section 150c corrects the gains in variable amplifier 121 and variable amplifier 131 according to ambient temperatures through gain correction section 151d and corrects, when a signal input to detection circuit 500 is a burst signal as in the case of gain correction section 151c, the gains in variable amplifier 121 and variable amplifier 131 according to the state (here, how often burst occurs). Through these corrections, gain correction section 151d causes the lower limit value of the detection range (see linear part 125a in FIG.7) of detector 122 to match the upper limit value of the detection range (see linear part 136a in FIG.7) of detector 132.

Thus, according to this embodiment, even when the characteristics of detector 122 and detector 132 fluctuate due to temperatures and the lower limit value of the detection range (see linear part 125a in FIG.7) of detector 122 does not match the upper limit value of the detection range (see linear part 136a in FIG.7) of detector 132, it is possible to correct the gains in amplifiers 121 and 131 determined by gain determining section 151a. Furthermore, it is possible to change the gains in variable amplifier 121 and variable amplifier 131 according to the frequency of bursts of input signals in such a way that detection level errors at detector 122 and detector 132 become smaller and thereby reduce deterioration of the detection characteristic associated with temperatures and reduce deterioration of accuracy when burst signals are detected.

### (Embodiment 5)

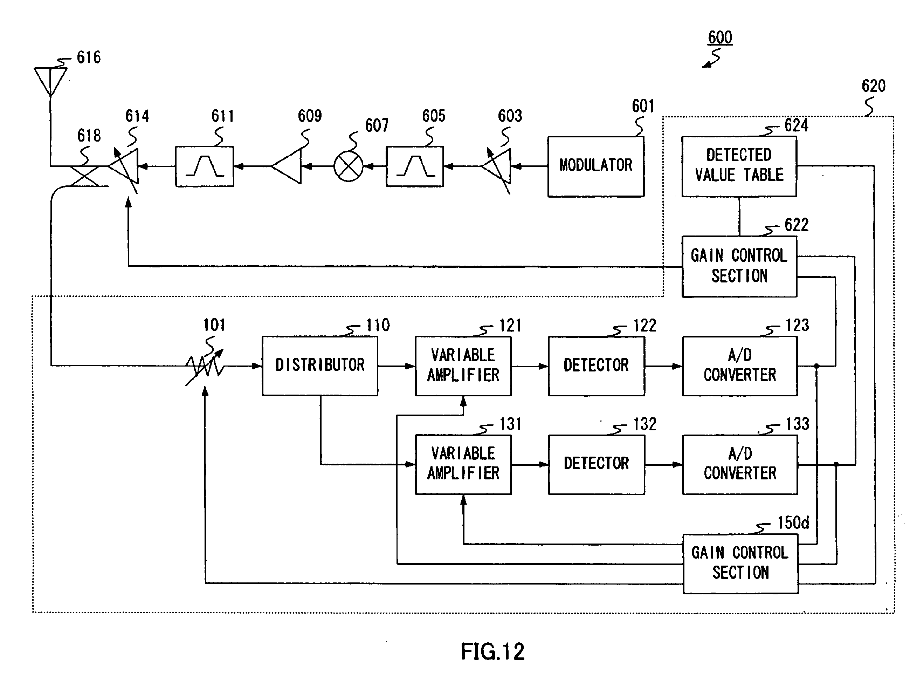

FIG.12 is a block diagram showing the configuration of transmission apparatus 600 according to Embodiment 5 of the present invention.

This transmission apparatus 600 includes modulator 601 that modulates a signal to be transmitted, first variable amplifier 603 that variable-amplifies the signal from modulator 601, first band limiting filter 605 that restricts the band of the variable-amplified signal, mixer 607 that up-converts the signal band-restricted by first band limiting filter 605, amplifier 609 that amplifies the up-converted signal, second band limiting filter 611 that restricts the band of the signal amplified by amplifiers 609, variable gain amplifier 614 that variable-amplifies the signal amplified by amplifier 609 by a gain so as to reach a desired signal level, antenna 616, coupler 618 that distributes part of the output signal of variable gain amplifier 614 and gain adjustment circuit section 620 that adjusts the gain in variable gain amplifier 614 using the signal input from coupler 618.

Gain adjustment circuit section 620 has a basic configuration similar to that of detection circuit 100 corresponding to Embodiment 1 shown in FIG.4 and the same components are assigned the same reference numerals and explanations thereof will be omitted.

Gain adjustment circuit section 620 includes detection circuit 100, gain control section 622 and detected value table 624.

As in the case of the above described gain control section 150, gain control section 150d monitors A/D converter 123 and A/D converter 133, adjusts and determines the gains in variable amplifier 121 and variable amplifier 131 and outputs the correspondence between the amount of attenuation in variable attenuator 101 and the output detected values of A/D converter 123 and A/D converter 133 to detected value table 624.

Gain control section 622 reads signals (detected values) output from A/D converter 123 and A/D converter 133, reads information stored in detected value table 624 and adjusts the gain in variable amplifier 614 that variable-amplifies a transmission signal using these detected value and information of the detected value table.

Detected value table 624 can be read and written by gain control section 150 d and gain control section 622 and stores the correspondence between an amount of attenuation in variable attenuator 101 and output detected values of A/D converter 123 and A/D converter 133 and signal levels of signals actually input to antenna 616 associated with each correspondence. The signal levels of signals actually input to antenna 616 are accurately measured using a power meter (not shown) and suchlike, at the input end of antenna 616. Such measured values measured using the power meter are stored.

Next, the operation of transmission apparatus 600 in the above described configuration will be explained.

First, a transmission signal is output at a maximum transmission level of the transmission apparatus of the present invention by adjusting variable amplifier 603 and variable amplifier 614. The transmission level at this time is accurately measured at the input end of antenna 616 using the power meter and suchlike.

The components of gain adjustment circuit section 620 similar to those of detection circuit 100 adjust and determine the gains in variable amplifier 121 and variable amplifier 131 and gain control section 150d stores in detected value table 624 automatically the correspondence between an amount of attenuation in variable attenuator 101 and the output detected values of the A/D converter 123 and A/D converter 133 at the time of adjustment when the gains in variable amplifier 121 and variable amplifier 131 are determined.

Furthermore, detected value table 624 stores the accurate signal levels measured using the power meter.

When transmitting a signal through modulator 601 to antenna 616, gain control section 622 reads the output detected values of A/D converter 123 and A/D converter 133, refers the read detected value to the information read into detected value table 624 and recognizes the signal level of the signal being transmitted from transmission apparatus 600.

Gain control section 622 compares the signal level at which the signal is actually being transmitted with a desired transmission signal level and increases or decreases the gain in variable amplifier 614 based on this comparison result.

Such a series of operations realizes automatic gain control in transmission apparatus 600.

Thus, according to this embodiment, detection circuit 100 of Embodiment 1 is applied for transmission apparatus 600 and detected value table 624 storing transmission signals and detected values makes it possible to accurately detect the signal level for transmission without measuring errors of detection signals generated by characteristic variations at variable amplifier 121 and variable amplifier 131 of gain adjustment circuit section 620 and to realize the automatic gain control function of transmission apparatus 600 with less time and effort.

### (Embodiment 6)

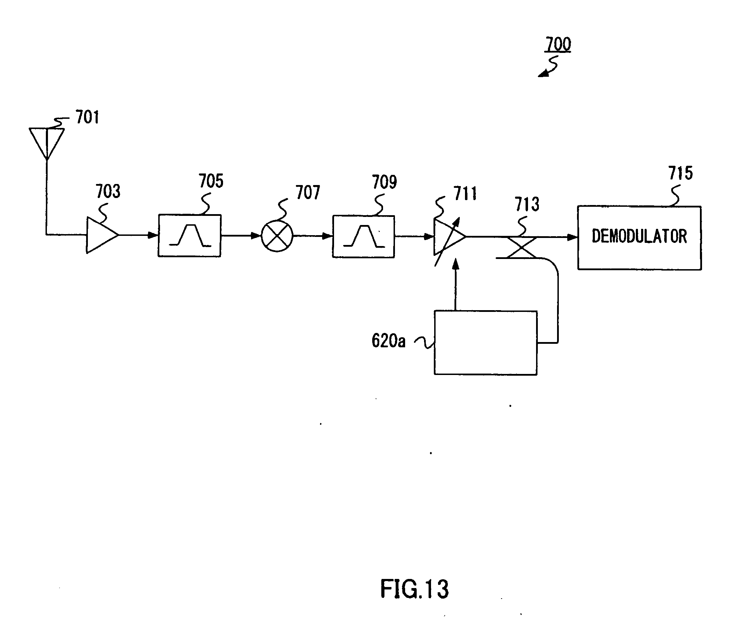

FIG.13 is a block diagram showing the configuration of a reception apparatus according to Embodiment 6 of the present invention.

Reception apparatus 700 is comprised of an apparatus that demodulates a transmitted signal installing gain control circuit section 620a configured the same way as gain control circuit section 620 used in Embodiment 5. Reception apparatus 700 according to Embodiment 6 shown in FIG.13 includes antenna 701, amplifier 703 that amplifies a signal received by antenna 701, first band limiting filter 705 that suppresses an unnecessary frequency band of the output signal of amplifier 703, mixer 707 that down-converts the signal band-restricted by first band limiting filter 705, second band limiting filter 709 that suppresses an unnecessary frequency band of the output signal of mixer 707, variable amplifier 711 that amplifies the signal band-restricted by second band limiting filter 709, coupler 713 that distributes part of the output signal of variable amplifier 711, demodulator 715 that demodulates the output signal of variable amplifier 711 and gain control circuit section 620a that detects part of the signal distributed from coupler 713.

Gain control circuit section 620a has a basic configuration similar to that of gain control circuit section 620 according to Embodiment 5 shown in FIG.12 except in that variable amplifier 614 that adjusts gains is replaced by variable amplifier 711. Therefore, the same components are assigned the same reference numerals and explanations thereof will be omitted.

Next, the operation of reception apparatus 700 in the above described configuration will be explained.

First, a received signal at a known signal level is input to antenna 701 in a pseudo manner. The signal input to antenna 701 in the pseudo manner is input to gain control circuit section 620a through amplifier 703, first band limiting filter 705, mixer 707, second band limiting filter 709, variable amplifier 711 and coupler 713.

As explained in Embodiment 5, when a signal is input to gain control circuit section 620a, gain control circuit section 620a determines the gains in variable amplifier 121 and variable amplifier 131 (seeFIG.12) in gain control circuit section 620a, further outputs the correspondence between the received signal level and detected value to detected value table 624 (see FIG.12) and automatically stores these corresponding values in detected value table 624.

The value of the correspondence between the received signal level and detected value stored in this detected value table is associated with the level of the signal actually received by antenna 701. The level of the signal actually received by antenna 701 is measured by a power meter (not shown) and suchlike provided at the output end of antenna 701 and the measured value is output to detected value table 624.

When reception apparatus 700 receives a signal, gain adjustment circuit section 620a compares the signal level of the actually received signal with the signal level of a desired received signal and increases or decreases the gain in variable amplifier 711 based on this comparison result.

Such a series of operations realizes automatic gain control in reception apparatus 700.

Thus, according to this Embodiment 6, gain control circuit section 620a according to Embodiment 5 having detection circuit 100 makes it possible to prevent measuring errors of detection signals due to characteristic variations at variable amplifier 121 and variable amplifier 131 of gain adjustment circuit section 620a having the detected value table which stores received signals and detected values, to detect accurately the received signal level with an expanded dynamic range and to realize the automatic gain control function of reception apparatus 700 with less time and effort.

In this regard, it is possible to create a program for realizing the function of adjusting the gains in variable amplifier 121 and variable amplifier 131 in the detection circuit realized by gain control section 150, 150a, 150b, 150c, 150d of any one of Embodiments 1 to 6 described above as well as the functions of gain control circuit section 620 and apply the program to circuits other than those in the above described configuration.

Especially, the program for gain adjustment of the variable gain amplifiers in detections carried out by gain control section 150 realizes the function performed by computers provided with a distributor that distributes an input signal to a plurality of sections and a plurality of variable gain amplifiers that amplify the distributed signals with different gains. And the function is to input signals at predetermined levels to the distributor and the function of detecting output signals output from the plurality of variable gain amplifiers and to determine the gains in the plurality of amplifiers in such a way that the linear characteristics of the plurality of variable gain amplifiers become continuous based on the detected output signals, that is, a lower limit value of a detection range of one variable gain amplifier that detects a signal at a high signal level matches a lower limit value of a detection range of a variable gain amplifier that detects a signal at a signal level lower than that of the one variable gain amplifier.

This program can realize the function according to Embodiment 1 described above performed by a computer provided with a distributor and plurality of amplifiers.

Transmission apparatus 600 and reception apparatus 700 corresponding to Embodiments 5 and 6 respectively have been explained as having a configuration provided with detection circuit 100 corresponding to Embodiment 1, but it is also possible to substitute this detection circuit 100 by detection circuit 300 to 500 corresponding to Embodiments 2 to 4 or detection circuit 200 corresponding to the modification example of Embodiment 1.

As explained so far, the present invention can easily expand the dynamic range while preventing deterioration of detection accuracy attributed to characteristic variations of devices such as amplifiers and detectors.

A first mode of the present invention is a detection circuit comprising an input signal level adjustment section that can adjust the level of an input signal of said detection circuit, a first variable amplification section that amplifies a signal output from the input signal level adjustment section by a first gain, a first detection section that detects the output signal of the first variable amplification section, a second variable amplification section that amplifies the signal output from the input signal level adjustment section by a second gain, a second detection section that detects the output signal of the second variable amplification section and a gain determining section that controls the first variable amplification section and the second variable amplification section while changing the level of the input signal of the detection circuit by controlling the input signal level adjustment section, and adjusts the first gain and the second gain in such a way that a lower limit value of the detection range of the first detection section matches an upper limit value of the detection range of the second detection section.

Since the detection circuit adjusts the first gain in the first variable amplification section and the second gain in the second variable amplification section while changing the signal level of the signal output from the signal output section and determines the first and second gains in such a way that the upper limit value of the detection range of the first detection section matches the lower limit value of the detection range of the second detection section, this configuration makes it possible to prevent deterioration of the detection accuracy attributed to characteristic variations of a device used for the variable amplification section or detection section and suchlike, to expand the dynamic range of the overall detection circuit through the detection ranges of the first detection section and second detection section which do not overlap with each other. That is, unlike the conventional detection circuit, there is no need to provide a relatively large margin in consideration of performance variations (characteristic variations) of components making up the detection section in the detection range of the detection section. Therefore, it is possible to reduce the margin and expand the detection range by an amount corresponding thereto.

Furthermore, even when the detection circuit with such an expanded dynamic range is used for a transmission apparatus or reception apparatus to realize the AGC function, the detection range of an input signal is wide and the detection accuracy improves and it is also possible to expand the range of the signal level of a signal to be received or transmitted.

A second mode of the present invention is the detection circuit in the above described configuration, further comprising a temperature detection section that detects an ambient temperature, a temperature gain correction table that stores amounts of correction for correcting the first gain and second gain determined by the gain determining section according to the ambient temperature and a gain correction section that corrects the first gain and second gain determined by the gain determining section based on the ambient temperature detected by the temperature detection section using the temperature gain correction table.

According to this configuration, the detection circuit reads the amount of correction corresponding to the temperature detected by the temperature detection section from the temperature gain correction table and corrects the first gain and second gain determined by the gain determining section according to the read amount of correction, and therefore even when characteristics of the first and second variable amplification sections or first and second detection sections change according to the temperature, the upper limit value of the detection range of the first detection section does not match the lower limit value of the detection range of the second detection section, the dynamic range becomes narrower and the detection accuracy deteriorates, it is possible to correct the first gain and second gain according to the ambient temperature, secure a wide dynamic range of the entire detection circuit and realize the detection circuit with small deterioration of the detection characteristic associated with temperatures.

A thirdmode of the present invention is the detection circuit in the above described configuration, further comprising a burst gain correction table that stores amounts of correction for correcting the first gain and second gain determined by the gain determining section according to the burst states of signals input to the first variable amplification section and the second variable amplification section and a gain correction section that corrects the first gain and second gain determined by the gain determining section based on the burst states of the signals input to the first variable amplification section and the second variable amplification section using the burst gain correction table.

According to this configuration, the detection circuit can correct the respective predetermined gains determined by the gain determining section according to the burst states of input signals, and therefore even when the input signals are in burst states, characteristics of the first and second variable amplification sections or first and second detection sections change, the upper limit value of the detection range of the first detection section does not match the lower limit value of the detection range of the second detection section and the detection accuracy deteriorates, it is possible to correct the first gain and second gain according to the ambient temperature, secure a wide dynamic range of the overall detection circuit and realize the detection circuit with small deterioration in the detection characteristic due to signal bursts.

A fourth mode of the present invention is a transmission apparatus comprising a gain amplification section that amplifies a transmission signal with a predetermined gain so as to reach a desired signal level, the detection circuit according to the first mode wherein part of the signal output from the gain amplification section is input to the output signal level adjustment section, a table that stores the relationship between the signal level output from the output signal level adjustment section of the detection circuit and the detected values of the first detection section and the second detection section of the detection circuit and a gain control section that controls the gain in the gain amplification section based on the detected values output from the first detection section and the second detection section using the table.

According to this configuration, part of the signal amplified by a gain by the gain amplification section using the table is input to the detection circuit and the gain in the gain amplification section is controlled based on the detected value obtained from the detection circuit, and therefore it is possible to realize an AGC function using the detection circuit with an expanded dynamic range.

That is, the gain control section can recognize the level of a signal input to the detection circuit from the detected value of the detection circuit with a wide dynamic range using the table, that is, the level of the transmission signal amplified by the amplification section by a gain and actually transmitted, and control the gain in the gain amplification section in such a way that the level of this transmission signal becomes a desired signal level.

Furthermore, according to the configuration of this transmission apparatus, the first variable amplification section and second variable amplification section in the detection circuit include the table which stores the relationship between the input signal level and detected value when the respective gains for which characteristic variations have been cleared are determined, and therefore it is not necessary to store the relationship with a characteristic wave value which varies from one transmission apparatus to another unlike the conventional transmission apparatus whose detected value is not constant due to characteristic variations. This configuration realizes the AGC function with less time and effort.

A fifth mode of the present invention is a reception apparatus comprising a gain amplification section that amplifies a received signal by a predetermined gain so as to reach a desired signal level, the detection circuit according to the first mode wherein part of the signal output from the gain amplification section is input to the output signal level adjustment section, a table that stores the relationship between the signal level output from the output signal level adjustment section of the detection circuit and the respective detected values of the first detection section and the second detection section of the detection circuit and a gain control section that controls the gain in the gain amplification section based on the respective detected values output from the first detection section and the second detection section using the table.

According to this configuration, the gain amplification section inputs part of a signal amplified by a gain to the detection circuit using the table and controls the gain in the gain amplification section based on the detected value obtained from the detection circuit, and therefore it is possible to realize an AGC function using a detection circuit with an expanded dynamic range.

That is, the gain control section can recognize the level of a signal input to the detection circuit from the detected value of the detection circuit with a wide dynamic range using the table, that is, the level of the received signal amplified by the amplification section by a gain and actually received and control the gain in the gain amplification section in such a way that the level of this received signal becomes a desired signal level.

Furthermore, according to the configuration of this reception apparatus, the first variable amplification section and second variable amplification section in the detection circuit include the table which stores the relationship between the input signal level and detected value when the respective gains for which characteristic variations have been cleared are determined, and therefore it is not necessary to store the relationship with a characteristic wave value which varies from one reception apparatus to another unlike the conventional reception apparatus whose detected value is not constant due to characteristic variations. This configuration realizes the AGC function with less time and effort.

A sixth mode of the present invention is a method of adjusting a detection circuit that includes a first variable amplification section that amplifies an input signal by a first gain and outputs the signal and a second variable amplification section that amplifies the input signal by a second gain and outputs the signal, comprising a step of inputting a signal at a predetermined level to the first variable amplification section and second variable amplification section, a step of detecting output signals output from the first variable amplification section and second variable amplification section and a step of determining the first gain and second gain in such a way that a lower limit value of the detection range detected from the first variable amplification section matches an upper limit value of the detection range detected from the second variable amplification section.

According to this method, inputting a signal at a predetermined level to the detection circuit adjusts the first gain in the first variable amplification section and the second gain in second variable amplification section so that the lower limit value of the detection range detected from the first variable amplification section matches the upper limit value of the detection range detected from the second variable amplification section, and therefore makes it possible to easily expand the dynamic range of the detection circuit while preventing deterioration of the detection accuracy attribute to characteristic variations of devices used to detect the first variable amplification section and second variable amplification section.

This application is based on Japanese Patent Application No.2003-146222 filed on May 23, 2003.

### Industrial Applicability

The present invention is applicable to a radio apparatus mounted in a mobile station apparatus and a base station apparatus and suchlike in a mobile communication system.
[FIG.1]
   - 10: DISTRIBUTOR
   - 21: AMPLIFIER
   - 22: DETECTOR
   - 23: A/D CONVERTER
   - 31: AMPLIFIER
   - 32: DETECTOR
   - 33: A/D CONVERTER
[FIG.2]
   DETECTED VALUE [V]
   DETECTED SIGNAL LEVEL [dB]
[FIG.3]
   DETECTED VALUE [V]
   DETECTED SIGNAL LEVEL [dB]
[FIG.4]
   - 110: DISTRIBUTOR
   - 121: VARIABLE AMPLIFIER
   - 122: DETECTOR
   - 123: A/D CONVERTER
   - 131: VARIABLE AMPLIFIER
   - 132: DETECTOR
   - 133: A/D CONVERTER
   - 150: GAIN CONTROL SECTION
[FIG.5]
   DETECTED VALUE [V]
   DETECTED SIGNAL LEVEL [dB]
[FIG.6]
   DETECTED VALUE [V]
   DETECTED SIGNAL LEVEL [dB]
[FIG.7]
   DETECTED VALUE [V]
   DETECTED SIGNAL LEVEL [dB]
[FIG.8]
   - 110: DISTRIBUTOR
   - 121: VARIABLE AMPLIFIER
   - 122: DETECTOR
   - 123: A/D CONVERTER
   - 131: VARIABLE AMPLIFIER
   - 132: DETECTOR
   - 133: A/D CONVERTER
   - 150: GAIN CONTROL SECTION
[FIG.9]
   - 110: DISTRIBUTOR
   - 121: VARIABLE AMPLIFIER
   - 122: DETECTOR
   - 123: A/D CONVERTER
   - 131: VARIABLE AMPLIFIER
   - 132: DETECTOR
   - 133: A/D CONVERTER
   - 150a: GAIN CONTROL SECTION
   - 151a: GAIN DETERMINING SECTION
   - 151b: GAIN CORRECTION SECTION
   - 301: TEMPERATURE SENSOR
   - 303: TEMPERATURE GAIN CORRECTION TABLE
[FIG.10]
   - 110: DISTRIBUTOR
   - 121: VARIABLE AMPLIFIER
   - 122: DETECTOR
   - 123: A/D CONVERTER
   - 131: VARIABLE AMPLIFIER
   - 132: DETECTOR
   - 133: A/D CONVERTER
   - 150b: GAIN CONTROL SECTION
   - 151a: GAIN DETERMINING SECTION
   BURST SIGNAL INFORMATION
   - 151c: GAIN CORRECTION SECTION
   - 401: BURST GAIN CORRECTION TABLE
[FIG.11]
   - 110: DISTRIBUTOR
   - 121: VARIABLE AMPLIFIER
   - 122: DETECTOR
   - 123: A/D CONVERTER
   - 131: VARIABLE AMPLIFIER
   - 132: DETECTOR
   - 133: A/D CONVERTER
   - 150a: GAIN CONTROL SECTION
   - 151a: GAIN DETERMINING SECTION
   BURST SIGNAL INFORMATION
   - 151d: GAIN CORRECTION SECTION
   - 501: TEMPERATURE SENSOR
   - 505: BURST GAIN CORRECTION TABLE
   - 503: TEMPERATURE GAIN CORRECTION TABLE
[FIG.12]
   - 601: MODULATOR
   - 624: DETECTED VALUE TABLE
   - 622: GAIN CONTROL SECTION
   - 110: DISTRIBUTOR
   - 121: VARIABLE AMPLIFIER
   - 122: DETECTOR
   - 123: A/D CONVERTER
   - 131: VARIABLE AMPLIFIER
   - 132: DETECTOR
   - 133: A/D CONVERTER
   - 150d: GAIN CONTROL SECTION
[FIG.13]
   - 715: DEMODULATOR

## Claims

1. A detection circuit (100) comprising:
an input signal level adjustment section (101) that can adjust the level of an input signal of said detection circuit (100);
a first variable amplification section (121) that amplifies a signal output from said input signal level adjustment section (101) by a first gain;
a first detection section (122,123) that detects an output signal of said first variable amplification section (121);
a second variable amplification section (131) that amplifies the signal output from said input signal level adjustment section (101) by a second gain;
a second detection section (132, 133) that detects an output signal of said second variable amplification section (131); and
a gain determining section (150) that controls said first variable amplification section (121) and said second variable amplification section (131) while changing the level of the input signal of said detection circuit (100) by controlling said input signal level adjustment section (101), and adjusts said first gain and said second gain in such a way that a lower limit value of a detection range (125a) of said first detection section (122) matches an upper limit value of a detection range (136a) of said second detection section (132).

2. The detection circuit according to claim 1, further comprising:
a temperature detection section that detects an ambient temperature;
a temperature gain correction table that stores amounts of correction for correcting the first gain and second gain determined by said gain determining section according to the ambient temperature; and
a gain correction section that corrects the first gain and second gain determined by said gain determining section based on the ambient temperature detected by said temperature detection section using said temperature gain correction table.

3. The detection circuit according to claim 1, further comprising:
a burst gain correction table that stores amounts of correction for correcting the first gain and second gain determined by said gain determining section according to the burst states of signals input to said first variable amplification section and said second variable amplification section; and
a gain correction section that corrects the first gain and second gain determined by said gain determining section based on the burst states of the signals input to said first variable amplification section and said second variable amplification section using said burst gain correction table.

4. A transmission apparatus comprising:
a gain amplification section that amplifies a transmission signal by a predetermined gain so as to reach a desired signal level;
the detection circuit according to claim 1 wherein part of the signal output from said gain amplification section is input to the output signal level adjustment section;
a table that stores the relationship between the signal level output from said output signal level adjustment section of said detection circuit and the respective detected values of said first detection section and said second detection section of said detection circuit; and
a gain control section that controls the gain in said gain amplification section based on the respective detected values output from said first detection section and said second detection section using said table.

5. A reception apparatus comprising:
a gain amplification section that amplifies a received signal by a predetermined gain so as to reach a desired signal level;
the detection circuit according to claim 1 wherein part of the signal output from said gain amplification section is input to the output signal level adjustment section;
a table that stores the relationship between the signal level output from said output signal level adjustment section of said detection circuit and the respective detected values of said first detection section and said second detection section of said detection circuit; and
a gain control section that controls the gain in said gain amplification section based on the respective detected values output from said first detection section and said second detection section using said table.

6. A method of adjusting a detection (100) circuit that includes a first variable amplification section (121) that amplifies an input signal by a first gain and outputs a first signal and a second variable amplification section (131) that amplifies said input signal by a second gain and outputs a second signal, comprising:
a step of inputting said input signal at a predetermined level to said first variable amplification section (121) and second variable amplification section (131);
a step of detecting output signals output from said first variable amplification section and second variable amplification section; and
a step of determining said first gain and second gain in such a way that a lower limit value of the detection range (125a) detected from said first variable amplification section (121) matches an upper limit value of the detection range (135a) detected from said second variable amplification section (132).

## Patentansprüche

1. Erfassungsschaltung (100), die umfasst:
einen Eingangssignalpegel-Regulierabschnitt (101), der den Pegel eines Eingangssignals der Erfassungsschaltung (100) regulieren kann;
einen ersten Abschnitt (121) variabler Verstärkung, der ein von dem Eingangssignalpegel-Regulierabschnitt (101) ausgegebenes Signal mit einem ersten Verstärkungsfaktor verstärkt;
einen ersten Erfassungsabschnitt (122, 123), der ein Ausgangssignal des ersten Abschnitts (121) variabler Verstärkung erfasst;
einen zweiten Abschnitt (131) variabler Verstärkung, der das von dem Eingangssignalpegel-Regulierabschnitt (101) ausgegebene Signal mit einem zweiten Verstärkungsfaktor verstärkt;
einen zweiten Erfassungsabschnitt (132, 133), der ein Ausgangssignal des zweiten Abschnitts (131) variabler Verstärkung erfasst; und
einen Verstärkungsfaktor-Bestimmungsabschnitt (150), der den ersten Abschnitt (121) variabler Verstärkung und den zweiten Abschnitt (131) variabler Verstärkung steuert und dabei den Pegel des Eingangssignals der Erfassungsschaltung (100) ändert, indem er den Eingangssignalpegel-Regulierabschnitt (101) steuert, und den ersten Verstärkungsfaktor sowie den zweiten Verstärkungsfaktor so reguliert, dass ein unterer Grenzwert eines Erfassungsbereiches (125a) des ersten Erfassungsabschnitts (122) einem oberen Grenzwert eines Erfassungsbereiches (136a) des zweiten Erfassungsabschnitts (132) entspricht.

2. Erfassungsschaltung nach Anspruch 1, die des Weiteren umfasst:
einen Temperaturerfassungsabschnitt, der eine Umgebungstemperatur erfasst;
eine Temperatur-Verstärkungsfaktor-Korrekturtabelle, die Maße der Korrektur zum Korrigieren des durch den Verstärkungsfaktor-Bestimmungsabschnitt bestimmten ersten Verstärkungsfaktors und zweiten Verstärkungsfaktors gemäß der Umgebungstemperatur speichert; und
einen Verstärkungsfaktor-Korrekturabschnitt, der den durch den Verstärkungsfaktor-Bestimmungsabschnitt bestimmten ersten Verstärkungsfaktor und zweiten Verstärkungsfaktor auf Basis der durch den Temperaturerfassungsabschnitt erfassten Umgebungstemperatur unter Verwendung der Temperatur-Verstärkungsfaktor-Korrekturtabelle korrigiert.

3. Erfassungsschaltung nach Anspruch 1, die des Weiteren umfasst:
eine Burst-Verstärkungsfaktor-Korrekturtabelle, die Maße der Korrektur zum Korrigieren des durch den Verstärkungsfaktor-Bestimmungsabschnitt bestimmten ersten Verstärkungsfaktors und zweiten Verstärkungsfaktors gemäß den Burst-Zuständen in den ersten Abschnitt variabler Verstärkung und den zweiten Abschnitt variabler Verstärkung eingegebener Signale speichert; und
einen Verstärkungsfaktor-Korrekturabschnitt, der den durch den Verstärkungsfaktor-Bestimmungsabschnitt bestimmten ersten Verstärkungsfaktor und zweiten Verstärkungsfaktor auf Basis der Burst-Zustände der in den ersten Abschnitt variabler Verstärkung und den zweiten Abschnitt variabler Verstärkung eingegebenen Signale unter Verwendung der Burst-Verstärkungsfaktor-Korrekturtabelle korrigiert.

4. Sendevorrichtung, die umfasst:
einen Verstärkungsfaktor-Verstärkungsabschnitt, der ein Sendesignal um einen vorgegebenen Verstärkungsfaktor verstärkt, um einen gewünschten Signalpegel zu erreichen;
die Erfassungsschaltung nach Anspruch 1, wobei ein Teil des von dem Verstärkungsfaktor-Verstärkungsabschnitt ausgegeben Signals in den Ausgangssignalpegel-Regulierabschnitt eingegeben wird;
eine Tabelle, die die Beziehung zwischen dem von dem Ausgangssignalpegel-Regulierabschnitt der Erfassungsschaltung ausgegebenen Signalpegel und den jeweiligen erfassten Werten des ersten Erfassungsabschnitts und des zweiten Erfassungsabschnitts der Erfassungsschaltung speichert; und
einen Verstärkungsfaktor-Steuerabschnitt, der den Verstärkungsfaktor in dem Verstärkungsfaktor-Verstärkungsabschnitt auf Basis der von dem ersten Erfassungsabschnitt und dem zweiten Erfassungsabschnitt ausgegebenen jeweiligen erfassten Werte unter Verwendung der Tabelle steuert.

5. Empfangsvorrichtung, die umfasst:
einen Verstärkungsfaktor-Verstärkungsabschnitt, der ein empfangenes Signal um einen vorgegebenen Verstärkungsfaktor verstärkt, um einen gewünschten Signalpegel zu erreichen;
die Erfassungsschaltung nach Anspruch 1, wobei ein Teil des von dem Verstärkungsfaktor-Verstärkungsabschnitt ausgegebenen Signals in den Ausgangssignalpegel-Regulierabschnitt eingegeben wird;
eine Tabelle, die die Beziehung zwischen dem von dem Ausgangssignalpegel-Regulierabschnitt der Erfassungsschaltung ausgegebenen Signalpegel und den jeweiligen erfassten Werten des ersten Erfassungsabschnitts und des zweiten Erfassungsabschnitts der Erfassungsschaltung speichert; und
einen Verstärkungsfaktor-Steuerabschnitt, der den Verstärkungsfaktor in dem Verstärkungsfaktor-Verstärkungsabschnitt auf Basis der von dem ersten Erfassungsabschnitt und dem zweiten Erfassungsabschnitt ausgegebenen jeweiligen erfassten Werte unter Verwendung der Tabelle steuert.

6. Verfahren zum Regulieren einer Erfassungsschaltung (100), die einen ersten Abschnitt variabler Verstärkung (121), der ein Eingangssignal um einen ersten Verstärkungsfaktor verstärkt und ein erstes Signal ausgibt, sowie einen zweiten Abschnitt (131) variabler Verstärkung enthält, der das Eingangssignal um einen zweiten Verstärkungsfaktor verstärkt und ein zweites Signal ausgibt, wobei es umfasst:
einen Schritt des Eingebens des Eingangssignals mit einem vorgegebenen Pegel in den ersten Abschnitt (121) variabler Verstärkung und den zweiten Abschnitt (131) variabler Verstärkung;
einen Schritt des Erfassens von Ausgangssignalen, die von dem ersten Abschnitt variabler Verstärkung und dem zweiten Abschnitt variabler Verstärkung ausgegeben werden; und
einen Schritt des Bestimmens des ersten Verstärkungsfaktors und des zweiten Verstärkungsfaktors, so dass ein von dem ersten Abschnitt (121) variabler Verstärkung erfasster unterer Grenzwert des Erfassungsbereiches (125a) einem von dem zweiten Abschnitt (132) variabler Verstärkung erfassten oberen Grenzwert des Erfassungsbereiches (135a) entspricht.

## Revendications

1. Circuit de détection (100) comprenant :
une section d'ajustement de niveau de signal d'entrée (101) qui peut ajuster le niveau d'un signal d'entrée dudit circuit de détection (100),
une première section d'amplification variable (121) qui amplifie un signal fourni en sortie à partir de ladite section d'ajustement de niveau de signal d'entrée (101) par un premier gain,
une première section de détection (122, 123) qui détecte un signal de sortie de ladite première section d'amplification variable (121),
une seconde section d'amplification variable (131) qui amplifie le signal fourni en sortie à partir de ladite section d'ajustement de niveau de signal d'entrée (101) par un second gain,
une seconde section de détection (132, 133) qui détecte un signal de sortie de ladite seconde section d'amplification variable (131), et
une section de détermination de gain (150) qui commande ladite première section d'amplification variable (121) et ladite seconde section d'amplification variable (131) tout en modifiant le niveau du signal d'entrée dudit circuit de détection (100) en commandant ladite section d'ajustement de niveau de signal d'entrée (101), et ajuste ledit premier gain et ledit second gain de telle façon qu'une valeur de limite inférieure d'une plage de détection (125a) de ladite première section de détection (122) corresponde à une valeur de limite supérieure d'une plage de détection (136a) de ladite seconde section de détection (132) .

2. Circuit de détection selon la revendication 1, comprenant en outre :
une section de détection de température qui détecte une température ambiante,
une table de correction de gain de température qui mémorise des quantités de correction destinées à corriger le premier gain et le second gain déterminés par ladite section de détermination de gain conformément à la température ambiante, et
une section de correction de gain qui corrige le premier gain et le second gain déterminés par ladite section de détermination de gain sur la base de la température ambiante détectée par ladite section de détection de température en utilisant ladite table de correction de gain de température.

3. Circuit de détection selon la revendication 1, comprenant en outre:
une table de correction de gain de salve qui mémorise des quantités de correction destinées à corriger le premier gain et le second gain déterminés par ladite section de détermination de gain conformément aux états de salve des signaux appliqués en entrée à ladite première section d'amplification variable et à ladite seconde section d'amplification variable, et
une section de correction de gain qui corrige le premier gain et le second gain déterminés par ladite section de détermination de gain sur la base des états de salve des signaux appliqués en entrée à ladite première section d'amplification variable et à ladite seconde section d'amplification variable en utilisant ladite table de correction de gain de salve.

4. Dispositif d'émission comprenant :
une section d'amplification de gain qui amplifie un signal d'émission par un gain prédéterminé de façon à atteindre un niveau de signal désiré,
le circuit de détection conforme à la revendication 1, dans lequel une partie du signal fourni en sortie à partir de ladite section d'amplification de gain est appliquée en entrée à la section d'ajustement de niveau de signal de sortie,
une table qui mémorise la relation entre le niveau de signal fourni en sortie à partir de ladite section d'ajustement de niveau de signal de sortie dudit circuit de détection et les valeurs détectées respectives de ladite première section de détection et de ladite seconde section de détection dudit circuit de détection, et
une section de commande de gain qui commande le gain dans ladite section d'amplification de gain sur la base des valeurs détectées respectives fournies en sortie à partir de ladite première section de détection et de ladite seconde section de détection en utilisant ladite table.

5. Dispositif de réception comprenant :
une section d'amplification de gain qui amplifie un signal reçu par un gain prédéterminé de façon à atteindre un niveau de signal désiré,
le circuit de détection conforme à la revendication 1 dans lequel une partie du signal fourni en sortie à partir de ladite section d'amplification de gain est appliquée en entrée à la section d'ajustement de niveau de signal de sortie,
une table qui mémorise la relation entre le niveau de signal fourni en sortie à partir de ladite section d'ajustement de niveau de signal de sortie dudit circuit de détection et les valeurs détectées respectives de ladite première section de détection et de ladite seconde section de détection dudit circuit de détection, et
une section de commande de gain qui commande le gain dans ladite section d'amplification de gain sur la base des valeurs détectées respectives fournies en sortie à partir de ladite première section de détection et de ladite seconde section de détection en utilisant ladite table.

6. Procédé d'ajustement d'un circuit de détection (100) qui comprend une première section d'amplification variable (121) qui amplifie un signal d'entrée par un premier gain et fournit en sortie un premier signal, et une seconde section d'amplification variable (131) qui amplifie ledit signal d'entrée par un second gain et fournit en sortie un second signal, comprenant :
une étape consistant à appliquer en entrée ledit signal d'entrée à un niveau prédéterminé auxdites première section d'amplification variable (121) et seconde section d'amplification variable (131),
une étape consistant à détecter des signaux de sortie fournis en sortie à partir desdites première section d'amplification variable et seconde section d'amplification variable, et
une étape consistant à déterminer lesdits premier gain et second gain de telle manière qu'une valeur de limite inférieure de la plage de détection (125a) détectée à partir de ladite première section d'amplification variable (121) correspond à une valeur de limite supérieure de la plage de détection (135a) détectée à partir de ladite seconde section d'amplification variable (132).
